Europäisches Patentamt

European Patent Office

Office européen des brevets

(11) Veröffentlichungsnummer: **0 600 148 A1**

## EUROPÄISCHE PATENTANMELDUNG

(21) Anmeldenummer: **93109436.1**

(22) Anmeldetag: **14.06.93**

(51) Int. Cl.5: **G01R 27/26**, G01D 5/24, G01L 9/12

(30) Priorität: **04.11.92 DE 4237196**

(43) Veröffentlichungstag der Anmeldung:
**08.06.94 Patentblatt 94/23**

(84) Benannte Vertragsstaaten:
**CH DE FR GB IT LI NL SE**

(71) Anmelder: **VEGA Grieshaber GmbH & Co.**
**Am Hohenstein 113**
**D-77761 Schiltach(DE)**

(72) Erfinder: **Raffalt, Felix, Dipl.-Ing. FH**
**Karl-May-Weg 7**
**W-7612 Fischerbach(DE)**

(74) Vertreter: **Patentanwälte Dipl.-Ing. Klaus**
**Westphal Dr.rer.nat. Otto Buchner Dr.rer.nat.**
**Bernd Mussgnug Dr.-Ing. Peter Neunert**
**Waldstrasse 33**
**D-78048 Villingen-Schwenningen (DE)**

(54) **Verfahren und Anordnung zur Kapazitätsmessung.**

(57) Bei der beschriebenen Anordnung zur Kapazitätsauswertung ist die zu messende Kapazität (1) einseitig dauerhaft mit festem Bezugspotential, vorzugsweise Massepotential des Gesamt-Sensors, verbunden, während der andere Anschluß der zu messenden Kapazität stets auf Nullpotential eines Integrators (4) gehalten wird. Um eine Aufladung/Entladung der Kapazität zu erreichen, wird das Nullpotential periodisch umgeschaltet. Durch die beschriebene Anordnung und das zugehörige Verfahren lassen sich auch kleine Kapazitätswerte oder -variationen mit hoher Genauigkeit erfassen.

Fig. 1

Rank Xerox (UK) Business Services
(3.10/3.09/3.3.4)

Die Erfindung betrifft ein Verfahren und eine Anordnung zur Kapazitätsmessung.

Kapazitive Sensoren, insbesondere kapazitive Druckaufnehmer, Temperatursensoren und dergleichen, zeigen oftmals nur eine sehr geringe nutzbare Kapazitätsänderung, die durch die elektronische Auswerteschaltung mit hoher Präzision ausgewertet werden muß. Hierbei wird häufig von der Methode des quantisierten elektrischen Ladungstransports Gebrauch gemacht, die als ladungsbalancierte Kapazitätsumschaltungs-Anordnung bezeichnet wird. Dieses Meßprinzip hat den Vorteil, daß die Schaltung weitgehend monolithisch -mit Ausnahme einiger größerer Kondensatoren- in CMOS-Technik als anwendungsspezifische integrierte Schaltung (ASIC = Application Specific Integrated Circuit) ausgeführt werden kann.

Bei diesem Meßverfahren wird dem Meßkondensator in einem ersten Meßschritt eine definierte Ladung aufgeprägt, indem eine definierte Spannung an ihn angelegt wird. Dieses im Meßkondensator gespeicherte Ladungsquantum wird im zweiten Meßschritt auf einen Speicherkondensator übertragen, dessen Spannung auf unterschiedliche Weise ausgewertet werden kann. Beispielsweise kann die Spannung unmittelbar als Maß für die zu messende physikalische Größe gewertet werden oder es können zahlreiche Ladungsquanten aufaddiert werden, wobei das Resultat die zu messende physikalische Größe repräsentiert. Alternativ können dem Speicherkondensator Ladungsquanten eines Meß- und eines Kompensationskondensators im Sinne einer Differenzbildung zugeführt werden, oder es können Ladungsquanten des Meßkondensators und - mit umgekehrter Polarität - eines Referenzkondensators dem Speicherkondensator in einem solchen Verhältnis aufgeschaltet werden, daß sich eine Ladungsbalance ergibt, wobei das Verhältnis den gesuchten Meßwert repräsentiert.

Bei diesem Meßverfahren kann ein Anschluß des Meßkondensators fest mit einem Anschluß des Speicherkondensators, der üblicherweise als Rückkopplungsimpedanz eines integrierenden Verstärkers geschaltet ist, verbunden sein, während der andere Anschluß des Meßkondensators zwischen einer definierten Spannungsquelle und dem nicht invertierenden, auf Referenzpotential gelegten Anschluß des integrierenden Verstärkers umgeschaltet wird. Da die verwendeten Schalter, Kondensatorzuleitungen und insbesondere der Verstärkereingang nicht frei von meßwertverfälschenden parasitären Kapazitäten sind, ergeben sich Meßungenauigkeiten, für deren Neutralisation und Elimination hoher Aufwand in Form von Abschirmungen, potentialmäßiger Festlegung der parasitären Kapazitäten über zusätzliche Schaltschritte und dergleichen erforderlich sind.

Insbesondere wenn der Sensor unter undefiniert wechselnden Kapazitätsverhältnissen, z. B. aufgrund unterschiedlicher Oberflächenfeuchte oder elektrischer Störeinkopplungen, einzusetzen ist, ist es von Vorteil, die dem Gehäuse bzw. dem zu messenden Medium zugewandte Elektrode des Meßkondensators stets auf konstantem Potential, vorzugsweise Schaltungsmasse, zu halten.

Diese Maßnahme ist beispielsweise aus der WO 91/09278 bekannt, die eine dem Oberbegriff der Patentansprüche 1 und 5 entsprechende Gestaltung zeigt. Bei einer solchen Schaltung muß zur Gewährleistung eines ungestörten Sensorbetriebs sowohl die Einkopplung der Meßwechselspannung als auch der Abgriff des Meßwerts über die zweite Elektrode des Meßkondensators erfolgen. Dabei ergibt sich aber normalerweise eine Parallelschaltung der Eingangskapazität der Auswerteelektronik mit der zu messenden Kapazität, was entsprechende Meßfehler bedingt. Um solche Meßfehler auszumerzen, sind zusätzliche Referenzmessungen und zusätzliche Schirme erforderlich, wobei allerdings insbesondere bei Auswertung sehr kleiner Kapazitätsänderungen oder variationen dennoch keine ausreichend hohe Meßgenauigkeit erhalten werden kann.

Weiterhin ist es aus der DE 34 13 849 A1 bekannt, die zu messende Kapazität mit einem Anschluß dauerhaft auf Bezugspotential zu halten und den anderen Kapazitätsanschluß zwischen einer Referenzspannungsquelle und einem Integrator umzuschalten, oder aber die zu messende Kapazität über zwei Schalter in Reihe zwischen die Referenzspannungsquelle und den Integrator zu legen und die Schalter, deren andere Anschlüsse mit Massepotential verbunden sind, gegenphasig umzuschalten. Bei der ersteren Variante wirken sich allerdings parasitäre Kapazitäten meßverfälschend aus, während bei letzterer Variante aufgrund fehlender einseitiger Masseanbindung der zu messenden Kapazität Umgebungseinflüsse zu Meßwertveränderungen führen können.

In der DE 28 19 516 A1 ist ein Kapazitäts-Spannungswandler beschrieben, mit dem Kapazitätsänderungen gemessen werden sollen. Die zu messende Kapazität wird zwischen Lade und Entladephasen umgeschaltet und ist über einen Schalter mit einem Integrator verbunden, der ein der zu messenden Kapazität entsprechendes Ausgangssignal erzeugt. Nachteilig an dieser Anordnung ist, daß die parasitäre Kapazität der Schaltelemente direkt in das Meßergebnis eingeht.

Der Erfindung liegt die Aufgabe zugrunde, ein Verfahren und eine Anordnung zur Kapazitätsauswertung zu schaffen, mit dem bzw. der sich auch kleine Kapazitätswerte/-variationen mit hoher Genauigkeit auswerten lassen.

Diese Aufgabe wird mit den im Patentanspruch 1 genannten Maßnahmen bzw. mit den Merkmalen des Patentanspruchs 5 gelöst.

Vorteilhafte Ausgestaltungen der Erfindung sind in den Unteransprüchen angegeben.

Bei der Erfindung wird somit der Meßkondensator mit einem Anschluß durchgehend auf Bezugspotential, das vorzugsweise dem Massepotential der Gesamtanordnung entspricht, gehalten, während der andere Anschluß der zu messenden Kapazität mit dem Sensor-Massepotential bzw. einem hiermit verknüpften Referenzpotential, d. h. insbesondere mit dem negativen Anschluß der Spannungsversorgung des integrierenden Verstärkers, gekoppelt ist. Um dennoch eine Aufladung/Entladung der zu messenden Kapazität zu erreichen, wird das Sensor-Massepotential umgeschaltet. Durch diese Pegelverschiebung des Sensor-Massepotentials läßt sich eine Aufladung der zu messenden Kapazität in der Ladephase erreichen, während in der Entladephase eine reduzierte Spannungsdifferenz, vorzugsweise 0 Volt, auftritt. Da der nicht-invertierende Eingang des integrierenden Verstärkers gleichfalls auf Sensor-Massepotential liegt, bildet sich an dessen invertierendem Eingang eine virtuelle Masse aus, so daß während der Ladungsübertragung weder an dem üblicherweise zwischen die zu messende Kapazität und den integrierenden Verstärker geschalteten Schalter noch an den Eingängen des integrierenden Verstärkers eine elektrische Spannung vorhanden ist. Daher beeinflußt die Eigenkapazität dieser Bauteile, die bis zu zehnmal so hoch wie die nutzbare Kapazitätsänderung der zu messenden Kapazität sein kann, den Ladungsübertragungsvorgang nicht, so daß äußerst hohe Genauigkeit erreichbar ist. Bei der Erfindung wirkt die gesamte, mit der zu messenden Kapazität in Verbindung stehende Auswerteelektronik selbst als Schirm, so daß die Eigenkapazitäten der Meßschaltung vollständig neutralisiert werden.

Um diese Umschaltung des Sensor-Massepotentials zu erreichen, ist vorzugsweise eine Hilfsspannungsquelle vorgesehen, die wahlweise zuschaltbar ist und eine definierte Potentialverschiebung bewirkt. Diese Hilfsspannungsquelle ist in vorteilhafter Ausgestaltung über Schalter wechselweise entweder mit der Versorgungsspannung des Gesamt-Sensors verbindbar oder zwischen deren negativen Anschluß und das Sensor-Massepotential schaltbar. Bei dieser Konstruktion läßt sich die Hilfsspannungsquelle in einfacher Weise durch einen Stützkondensator realisieren, der periodisch durch die Gesamt-Spannungsversorgung aufgeladen wird und somit auf dem definierten Potential der Gesamt-Spannungsversorgung bleibt. Damit ist sichergestellt, daß die Größe der an die Auswertekomponenten einschließlich des integrierenden Verstärkers angelegten Versorgungsspannung stets konstant ist, unabhängig von der Umschaltung des Massepotentials.

Um bei einfachem Aufbau auch eine wiederholte Durchführung der Aufladung/Entladung der zu messenden Kapazität mit entsprechender Erhöhung der Meßgenauigkeit zu ermöglichen, ist in an sich bekannter Weise die zu messende Kapazität mit dem Mittelkontakt eines Umschalters verbunden, der zwischen den beiden Eingängen des integrierenden Verstärkers umschaltet und hierbei durch eine Schaltersteuerschaltung entsprechend gesteuert wird.

Eine Auswertung nach dem Prinzip des zeitlich mittleren Ladungsgleichgewichts wird durch Einsatz eines Referenzkondensators ermöglicht, der, über einen zweiten Umschalter, in gleicher Weise verschaltet ist wie die zu messende Kapazität.

Vorzugsweise werden die Umschalter zeitversetzt zur Umschaltung des Sensor-Massepotentials umgeschaltet, so daß die Schaltzeiten nicht in die Messung eingehen, da sich die Umschalter zum Zeitpunkt der Ladungsübertragung bereits im eingeschwungenen Zustand befinden.

In bevorzugter Ausgestaltung wird die Schaltersteuerschaltung mit einem Taktsignal gespeist, das durch Umschaltung zwischen den beiden Anschlüssen der Hilfsspannungsquelle gebildet wird. Hierdurch wird ein definierter Taktsignalverlauf erreicht, der nicht durch die Umschaltvorgänge der Hilfsspannungsquelle zwischen den Anschlüssen der Gesamt-Spannungsversorgung beeinflußt ist. Eine schaltungstechnisch einfache Realisierung des Zeitversatzes zwischen der Umschaltung des Sensor-Massepotentials und der Umschaltung der mit der zu messenden Kapazität bzw. dem Referenzkondensator verbundenen Umschalter läßt sich dadurch erreichen, daß der Schalttakt für die Sensor-Massepotential-Umschaltung über einen Phasenschieber an den Umschalter der Schaltersteuerschaltung angelegt wird, so daß deren Takteingangssignal gegenüber der Sensor-Massepotential-Umschaltung phasenversetzt ist. Dieser Phasenversatz kann durch Einsatz eines durch einen Oszillator gesteuerten Frequenzteilers und eines mit diesem verbundenen taktgesteuerten Flip-Flops realisiert werden, dessen Takteingang durch den Oszillator gesteuert wird. Dies hat den Vorteil, daß selbst bei eventuellen Frequenz- und/oder Amplitudenverschiebungen des Oszillatorausgangssignals stets ein definierter Phasenversatz aufrechterhalten wird, so daß die zeitversetzte Steuerung zwischen der Sensor-Massepotential-Umschaltung und der Umschlatung der mit der zu messenden Kapazität und/oder dem Referenzkondensator verbundenen Umschalter stets in präziser Weise aufrechterhalten wird.

Die Kapazitätsermittlung erfolgt in bevorzugter Weise über die Integration der jeweils gespeicherten Ladung für eine vorbestimmte Anzahl von Ladephasen, wonach dann die zur Rückintegration auf einen vorbestimmten Wert, vorzugsweise den Ausgangswert zu Beginn der Aufintegration, erforderliche Anzahl der Ladephasen des jeweils anderen Kondensators gezählt wird. Durch Mehrfachwiederholung dieser Auf-/Rückintegrations-Zyklen läßt sich die Meßgenauigkeit erheblich steigern.

Hierbei ist es von Vorteil, wenn während des Gesamt-Meßzyklus die Polaritäten der Aufladung/Entladung der zu messenden Kapazität bzw. des Referenzkondensators umgekehrt werden. Durch diese Maßnahme lassen sich eine evtl. vorhandene Offsetspannung des integrierenden Verstärkers sowie evtl. Eingangsströme kompensieren, so daß die Meßgenauigkeit noch weiter verbessert ist. Damit auch nach dieser Auf-/Entladungs-Polaritäts-Umkehr das System taktsynchron weiterarbeiten kann und keine besonderen Eingriffe in die Schlatung erforderlich sind, ist vorzugsweise eine Torschaltungsanordnung vorhanden, die in der zweiten Meßzyklushälfte die Signalanlegung an die zu messende Kapazität bzw. den Referenzkondensator invertiert und hierdurch die Polaritätsumkehrung bewirkt.

Damit eine automatiche Umschaltung von der Rückintegrationsphase auf die Aufwärtsintegrationsphase in definierter und einfacher Weise erreicht wird, ist der Ausgang des integrierenden Verstärkers vorzugsweise mit einem Schwellwertvergleicher verbunden, der bei Erreichen des Schwellwerts ein entsprechendes Umschaltsignal erzeugt. Um eine Zerstückelung eines gerade laufenden Ladungstransfers beim Umschalten des Schwellwertvergleichers zu vermeiden, ist vorzugsweise ein Verzögerungsglied vorhanden, das die sofortige Weiterleitung des Schwellwertvergleicher-Umschaltsignals bis zu Beendigung des Ladungstransfers sperrt. Hierdurch läßt sich sicherstellen, daß stets nur vollständige Ladungstransfers in das Gesamt-Zählergebnis eingehen. Eine dabei evtl. auftretende, zu viel gemessene Referenzteilladung geht direkt in den nächsten Meßzyklus ein und wird daher bei diesem berücksichtigt. Durch mehrfache Wiederholung dieser Meßzyklen läßt sich somit die Auflösung des Meßwerts entsprechend steigern und zwar über die bei sofortigem Abbruch des Ladungstransfers bei Ansprechen des Schwellwertvergleichers erreichbare Genauigkeit hinaus. Das Verzögerungsglied läßt sich in schaltungstechnisch einfacher Weise als taktgesteuertes Flip-Flop ausbilden.

Eine Wirkleitwertkompensation läßt sich dadurch erreichen, daß das Referenzpotential auf dem halben Wert der internen Versorgungsspannung, vorzugsweise dem halben Wert der Spannung der Hilfsspannungsquelle, liegt.

Die erfindungsgemäße Anordnung kann auch zur einfachen, exakten Temperaturmessung eines Sensors eingesetzt werden. Hierbei wird als zu messende Kapazität ein temperaturabhängiger Kondensator eingesetzt, der mit dem Sensor thermisch gekoppelt ist.

Zudem kann zur Kennlinienlinearisierung und Temperaturkompensation ein Speicher zur Aufnahme von Stützwerten, die das Kennlinienverhalten des gemessenen Sensors in Abhängigkeit von dem jeweiligen Meßparameter repräsentieren, vorhanden sein, wobei eine Steuereinrichtung zur Kennlinienkorrektur des gemessenen Sensors die Anzahl der Meßladungsübertragung in Abhängigkeit vom Sensor-Meßwert variiert.

Mit der Erfindung lassen sich die vorstehend genannten Vorteile erzielen und eine hochpräzise Messung realisieren, die nicht durch Eigenkapazitäten der beteiligten Baukomponenten oder durch Offsetspannungen bzw. durch elektromagnetische Einstreuung beeinträchtigt ist. Durch die phasenselektive Auswertung der Meßströme werden elektromagnetische Einstreuungen in den Sensor nicht gemessen.

Die Erfindung wird nachstehend anhand von Ausführungsbeispielen unter Bezugnahme auf die Zeichnungen näher beschrieben. Es zeigen:

Figur 1: ein Prinzipschaltbild der erfindungsgemäßen Anordnung während der Ladephase der zu messenden Kapazität;

Figur 2: ein der Figur 1 ähnliches Prinzipschaltbild während der Entladephase der zu messenden Kapazität;

Figur 3: ein detailliertes Blockschaltbild der erfindungsgemäßen Anordnung;

Figur 4: mehrere Signalverläufe, die während des Meßzyklus auftreten können, und

Figur 5 ein schematisches Prinzipschaltbild der erfindinngsgemäßen Anordnung, die für die Messung mehrerer Kapazitäten ausgelegt ist.

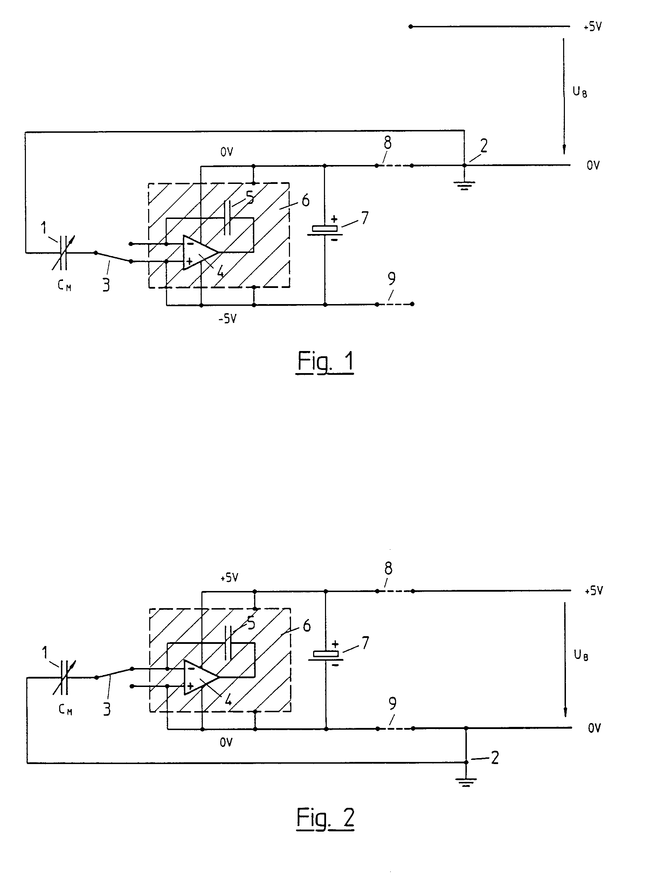

In Figur 1 ist ein Prinzipschaltbild der erfindinngsgemäßen Anordnung dargestellt, und zwar während der Ladephase einer zu messenden Kapazität 1. Die zu messende Kapazität 1 ist mit einem Anschluß 2 mit Bezugspotential, vorzugsweise Massepotential des Gesamt-Sensors verbunden, während der andere Anschluß der zu messenden Kapazität 1 über einen Umschalter 3 wechselweise zwischen den beiden Eingängen eines integrierenden Verstärkers 4 umschaltbar ist, der einen Bestandteil einer lediglich schematisch veranschaulichten Auswerteschaltung 6 bildet und in seinem Gegenkopplungszweig einen Kondensator 5 aufweist. In der Ladephase ist die zu messende Kapazität 1 mit dem nicht-invertierenden Eingang des integrierenden Verstärkers 4 verbunden, der mit einem Pol der Spannungsversorgung der Auswerteschaltung 6 verbunden ist. In der Ladephase liegt dieser Pol auf dem Potential -5 V, während der andere Anschluß der Spannungsversorgung der Auswerteschaltung 6 auf 0 V liegt. Die Potentialdifferenz von 5 V wird durch eine zwischen die beiden Spannungsversorgungsanschlüsse der Auswerteschaltung 6 geschaltete Hilfsspannungsquelle 7 aufrechterhalten. Über zwei synchron gesteuerte Umschalter 8, 9 läßt sich die Verbindung zwischen der Hilfsspannungsquelle 7 und den Anschlüssen der Versorgungsspannung für die Gesamtschaltung umschalten.

In Figur 2 ist die in Figur 1 gezeigte Schaltung im Schaltzustand während der Entladephase der zu messenden Kapazität gezeigt. Die zu messende Kapazität 1 ist nun über den Umschalter 3 auf den invertierenden Eingang des integrierenden Verstärkers 4 geschaltet, so daß die während der Ladephase (Figur 1) in der Meßkapazität 1 gespeicherte Ladung in den Kondensator 5 übertragen wird. Die Spannungsversorgung des integrierenden Verstärkers 4 und der Auswerteschaltung 6 ist über die Umschalter 8, 9 nun so mit der Gesamt-Versorgungsspannungsquelle verbunden, daß der nicht invertierende Eingang des integrierenden Verstärkers 4 und der hiermit verbundene Spannungsanschluß auf dem Potential 0 V liegt, während das Potential der anderen, mit dem Umschalter 8 verbundenen Speisespannungsklemme +5 V beträgt. Die Größe des Potentialunterschiedes der Versorgungsspannung der Auswerteschaltung 6 ist somit in der Ladephase und der Entladephase stets gleich, es wird lediglich die relative Lage des Versorgungspotentials, bezogen auf das Potential der Gesamtschaltung, verschoben. Durch entsprechende Wiederholung der Umschaltung der Schalter 3, 8 und 9 läßt sich die Aufladung/Entladung der zu messenden Kapazität 1 beliebig oft wiederholen, so daß eine entsprechende Vielzahl von Ladungspaketen im Kondensator 5 gespeichert wird und somit die Meßgenauigkeit erhöht wird. Bei der erfindungsgemäßen Anordnung bleibt somit der eine Anschluß 2 der Meßkapazität 1 unterbrechungslos mit dem Massepotential des Gesamt-Sensors (Erdpotential) verbunden, während die Versorgungsspannung der Auswerteschaltung 6 zyklisch potentialverschoben wird. Die Auswerteschaltung 6 wird somit im Takt des Umschaltsignals der Schalter 8, 9, das eine hochfrequente Rechteckspannung darstellt und zugleich die Umlade-Meßfrequenz für die Meßkapazität bildet, periodisch alternierend von den Sensor-Versorgungsanschlüssen getrennt und mit ihrem positiven Betriebsspannungsanschluß an den Minusanschluß der Sensor-Versorgungsspannung gelegt. Dies hat zugleich zur Folge, daß zwischen den Anschlüssen des Meßkondensators im Rhythmus der hochfrequenten Rechteckspannung alternierend die volle Sensor-Versorgungsspannung in der Ladephase auftritt, während in der Entladephase die Spannungsdifferenz 0 V beträgt.

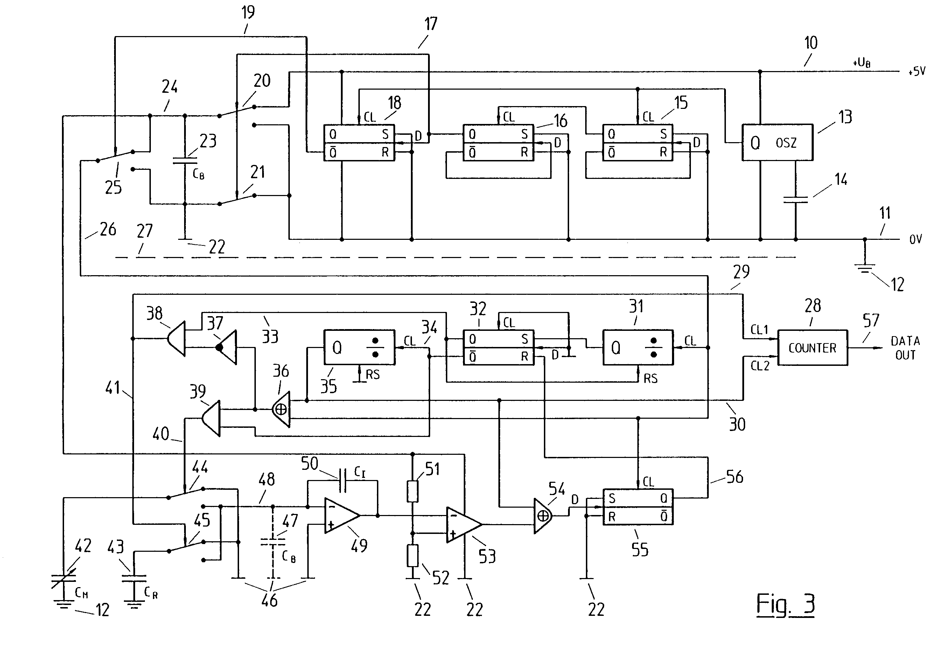

In Figur 3 ist ein detailliertes Blockschaltbild eines Ausführungsbeispiels der erfindungsgemäßen Anordnung gezeigt. Zwischen Leitungen 10, 11 liegt kontinuierlich die konstante Versorgungsspannung der gesamten Anordung, d. h. des Gesamt-Sensors an, die im Ausführungsbeispiel 5 V beträgt. Die Leitung 11 ist mit Bezugspotential, nämlich Massepotential 12 des Gesamt-Sensors (Erdpotential) verbunden. Zwischen die Leitungen 10, 11 ist ein Rechteckoszillator 13 geschaltet, dessen Frequenz durch einen Kondensator 14 bestimmt wird und der ein hochfrequentes Ausgangssignal erzeugt. Zur Frequenzteilung des Ausgangssignals des Oszillators 13 ist ein Frequenzteiler aus zwei Flip-Flops 15, 16 vorhanden. Das Ausgangssignal des Frequenzteilers 15, 16 dient als erstes Taktsignal, das auf einer Leitung 17 auftritt, und wird zugleich einem Eingang eines weiteren Flip-Flops 18 zugeführt, so daß dessen an seinem invertierenden Q-Ausgang über eine Leitung 19 abgegriffenes Ausgangssignal zu einem Zeitpunkt wechselt, der um 90° gegenüber der Flanke des Taktsignals auf der Leitung 17 phasenverschoben ist. Dies wird dadurch erreicht, daß das Ausgangssignal des Oszillators 13, das vierfach höhere Frequenz als das Ausgangssignal des Frequenzteilers 15, 16 besitzt, an den Takteingang des Flip-Flops 18 angelegt wird. Anstelle des Einsatzes des Oszillators 13 und des Frequenzteilers 15, 16 ist es auch möglich, einen Oszillator zu verwenden, der eine entsprechend verringerte Frequenz abgibt. In diesem Fall kann das Flip-Flop 18 auch durch einen entsprechenden Phasenschieber ersetzt werden.

Das auf der Leitung 17 auftretende erste Taktsignal wird als Umschaltsignal an einen Umschalter 20 und einen Schalter 21 angelegt, die synchron umschalten. Der Umschalter 20 schaltet zwischen den Leitungen 10, 11 um, während der Schalter 21 die Verbindung zwischen der Leitung 11 und Massepotential bzw. Nullpotential, dargestellt durch die Masse 22 eines Speicherkondensators 23, öffnet und schließt. Der Speicherkondensator 23 entspricht der Hilfsspannungsquelle 7 in den Figuren 1, 2. Der positive Anschluß des Speicherkondensators 23 ist mit dem Mittelkontakt des Umschalters 20 verbunden und wird somit zwischen dem positiven Anschluß der Gesamt-Versorgungsspannung und Erdpotential umgeschaltet. Der negative Anschluß des Speicherkondensators 23 ist mit einem Kontakt des Schalters 21 und mit Masse 22 verbunden. Aufgrund dieser Verschaltung wird der Speicherkondensator 23 stets auf den Wert der Sensor-Versorgungsspannung aufgeladen, springt aber im Rhythmus des Taktsignals auf der Leitung 17 an seinen beiden Anschlüssen um den Betrag der Versorgungsspannung periodisch hin und her. Wenn der Pegel des ersten Taktsignals niedrig ist, befinden sich die Schalter 20, 21 in der dargestellten Stellung, so daß die Masse 22 des Speicherkondensators 23 auf demselben Potential liegt wie das Potential 12. Bei hohem Pegel des Taktsignals auf der Leitung 17 liegt aber die Masse 22 um den Wert der Versorgungsspannung niedriger als das Potential 12. Die zwischen den beiden Anschlüssen des Speicherkondensators 23 auftretende Spannung, d. h. die Spannung zwischen einer mit dem positiven Anschluß des Speicherkondensators 23 verbundenen Leitung 24 und der Masse 22, dient zur Spannungsversorgung aller Schaltungsteile, die sich gemäß Figur 3 unterhalb einer Linie 27 befinden.

Das vom Flip-Flop 18 erzeugte phasenverschobene zweite Taktsignal auf der Leitung 19 steuert einen elektronischen Umschalter 25, dessen Mittelkontakt mit einer Leitung 26 und über diese mit einer nachstehend noch näher beschriebenen Schaltersteuerschaltung verbunden ist, während seine beiden Schaltkontakte mit den beiden Anschlüssen des Speicherkondensators 23, d. h. mit der Leitung 24 bzw. mit Masse 22 verbunden sind. Aufgrund des Phasenversatzes zwischen den beiden Taktsignalen auf den Leitungen 17, 19 fallen die Umschalt-Zeitpunkte der Schalter 20, 21 einerseits und des Schalters 25 andererseits, nicht zusammen.

Das über den Schalter 25 gewonnene Taktsignal wird über die Leitung 26 an einen Eingang eines Exklusiv-Oder-Gatters 36 angelegt, dessen zweiter Eingang durch den Ausgang eines später näher beschrieben Teilers 35 gesteuert wird. Der Ausgang des Exklusiv-Oder-Gatters 36 ist über einen Inverter 37 mit einem Eingang eines Und-Gatters 38 verbunden, dessen anderer Eingang über eine Leitung 33 mit dem nicht-invertierenden Ausgang eines nachstehend näher beschriebenen Flip-Flops 32 gekoppelt ist. Der Ausgang des Und-Gatters 38 ist über eine Leitung 41 mit dem Steuereingang eines elektronischen Umschalters 45 verbunden.

Der Ausgang des Exklusiv-Oder-Gatters 36 ist weiterhin mit einem Eingang eines Und-Gatters 39 verbunden, dessen anderer Eingang über eine Leitung 34 mit dem invertierenden Ausgang des Flip-Flops 32 gekoppelt ist. Der Ausgang des Und-Gatters 39 ist über eine Leitung 40 mit dem Steuereingang eines elektronischen Umschalters 44 verbunden.

Eine zu messende Kapazität 42 ist mit einem Anschluß dauerhaft mit Bezugspotential, vorzugsweise dem Erdpotential 12, verbunden, während der andere Anschluß mit dem Mittelkontakt des Umschalters 44 verbunden ist. In gleicher Weise ist ein Referenzkondensator 43 mit seinem einen Anschluß mit dem Bezugspotential, vorzugsweise Erdpotential 12, gekoppelt, während sein anderer Anschluß mit dem Mittelkontakt des Umschalters 45 verbunden ist.

Die Schaltkontakte der Umschalter 44, 45 sind jeweils parallel geschaltet, wobei der jeweils in Figur 3 oben dargestellte Schaltkontakt mit Sensor-Massepotential 46, d. h. der Masse 22, verbunden ist, während der jeweils untere Schaltkontakt der Umschalter 44, 45 über eine Leitung 48 mit dem invertierenden Eingang eines integrierenden Verstärkers 49 verbunden sind, in dessen Gegenkopplungszweig ein Integrierkondensator (Speicherkondensator) 50 liegt.

Der nicht-invertierende Eingang des integrierenden Verstärkers 49 ist gleichfalls direkt mit Sensor-Massepotential 46 bzw. 22 verbunden.

Der Ausgang des integrierenden Verstärkers 49 ist mit dem invertierenden Eingang eines SchwellwertvergleicherS 53 verbunden, dessen nicht-invertierender Eingang mit dem Abgriff eines parallel zum Speicherkondensator 23 geschalteten Widerstandsteilers aus Widerständen 51, 52 gekoppelt ist und über diesen mit der Vergleichs-Referenzspannung beaufschlagt wird. Der Ausgang des Schwellwertvergleichers 53 ist mit einem Eingang eines Exklusiv-Oder-Gatters 54 gekoppelt, dessen anderer Eingang über eine Leitung 30 mit dem Ausgang des Teilers 35 verbunden ist. Der Ausgang des Exklusiv-Oder-Gatters 54 liegt am D-Eingang eines D-Flip-Flops 55 an, dessen nicht-invertierender Ausgang über eine Leitung 56 mit dem Rücksetz-Eingang des Flip-Flops 32 verbunden ist.

Im folgenden wird die Wirkungsweise der vorstehend beschriebenen Schaltung näher erläutert: Das über den Umschalter 25 abgegriffene, auf der Leitung 26 auftretende Taktsignal steuert über die Gatter 36 bis 39 die als Halbleiterschalter ausgebildeten Umschalter 44, 45. Die Umschalter 44, 45 wirken als taktgesteuerte Synchrongleichrichter für den durch die zu messende Kapazität 42 bzw. den Referenzkondensator 43 fließenden Meß- bzw. Referenzstrom.

Im folgenden wird der Fall der Aufladung/Entladung der zu messenden Kapazität 42 betrachtet. Befindet sich das Flip-Flop 32 im nicht-gesetzten Zustand, so ist das Und-Gatter 38 gesperrt, während das Und-Gatter 39 geöffnet ist und somit das auf der Leitung 26 auftretende Taktsignal durchläßt. Wenn sich das Ausgangssignal des Teilers bzw. Zählers 35 auf niedrigem Pegel befindet, wird das Taktsignal auf der Leitung 26 unverändert durch das Exklusiv-Oder-Gatter 36 durchgelassen und gelangt somit weiterhin unverändert über das Und-Gatter 39 auf die Leitung 40. Somit steht zum Zeitpunkt der steigenden Flanke der Masse 22, bezogen auf das Potential 12, am Steuereingang des Umschalters 44 ein Signal hohen Pegels an, so daß der Umschalter 44 auf den unteren Schaltkontakt umgeschaltet ist. Bedingt durch die Änderungen des Massepotentials überträgt daher die zu messende Kapazität 42 ihre Ladung in den Rückkopplungskondensator 50 des integrierenden Verstärkers 49. Danach wechselt der Pegel des Steuersignals des Umschalters 44 aufgrund der taktgesteuerten Umschaltung des Umschalters 25, so daß der Umschalter 44 auf den mit Sensor-Massepotential 46 verbundenen Schaltkontakt umschaltet. Bei der nachfolgenden Umschaltung der Umschalter 20, 21 tritt eine abfallende Flanke des Massepotentials 22 auf, so daß die zu messende Kapazität 42 nun direkt über das Sensor-Massepotential 46 bzw. 22 wieder aufgeladen wird.

Während jeder Periodendauer des Taktsignals auf der Leitung 17 wird somit die zu messende Kapazität 42 einmal aufgeladen und wieder entladen. Daher wird die jeweils in der zu messenden Kapazität 42 gespeicherte Ladungsmenge wiederholt einmal je Periode in den Speicherkondensator 50 umgeladen. Da der nicht-invertierende Eingang des integrierenden Verstärkers 49 hierbei auf Massepotential 46 liegt, bildet sich an dem mit den Umschaltern 44, 45 verbundenen invertierenden Eingang des integrierenden Verstärkers 49 eine virtuelle Masse aus. Daher entsteht während der Ladungsübertragung weder an den elektronischen Umschaltern 44, 45 noch an den Eingängen des integrierenden Operationsverstärkers 49 eine elektrische Spannung. Folglich geht die Eigenkapazität dieser Bauteile, die bis zu zehnmal so hoch sein kann wie die nutzbare Kapazitätsänderung der zu messenden Kapazität 42, nicht in die Ladungsübertragung ein und verfälscht diese folglich nicht.

Als weiterer Vorteil ergibt sich, daß der Eingang der Umschalter 44, 45 gegenüber dem an den Anschlüssen des Speicherkondensators 23 abgegriffenen Versorgungs-potential der Auswerteelektronik wechselspannungsmäßig keinen Hub aufweist, wodurch alle Koppelkapazitäten zwischen den Kapazitäten 42, 43 und der Auswerteelektronik neutralisiert werden. Folglich wirkt der gesamte durch den Speicherkondensator 23 versorgte Teil der Meßanordnung als intrinsischer Schirm gegenüber den Kapazitäten 42, 43. Des weiteren weisen auch die Kapazitäten 42, 43 zueinander keine Spannungsdifferenz auf, wodurch die zwischen ihnen vorhandenen Koppelkapazitäten gleichfalls neu-tralisiert werden. Es kann somit selektiv störungsfrei die Kapazität 42 oder der Referenzkondensator 43 je nach Durchlaßzustand der Und-Gatter 38, 39 und der Taktung der Umschalter 44, 45 ausgewertet werden.

Die 90°-Phasenverschiebung zwischen den beiden Taktsignalen auf den Leitungen 17, 19 führt dazu, daß sich die Umschalter 44, 45 zum Zeitpunkt der Ladungsübertragung bereits im eingeschwungenen Zustand befinden, so daß die Schaltzeiten der Halbleiter-Umschalter 20, 21, 25, 44 und 45 nicht in die Messung eingehen.

Die Ausgangsspannung des integrierenden Verstärkers 49 ändert sich bei jedem Ladungs-Übertragungsvorgang, d. h. bei jeder Entladung, um den Betrag $\Delta U = U_B \times C_M / C_I$,
wobei $U_B$ die zwischen den Leitungen 10, 11 anliegende Versorgungsspannung, $C_M$ die Kapazität der zu messenden Kapazität und $C_I$ die Kapazität des Speicherkondensators 50 bezeichnen.

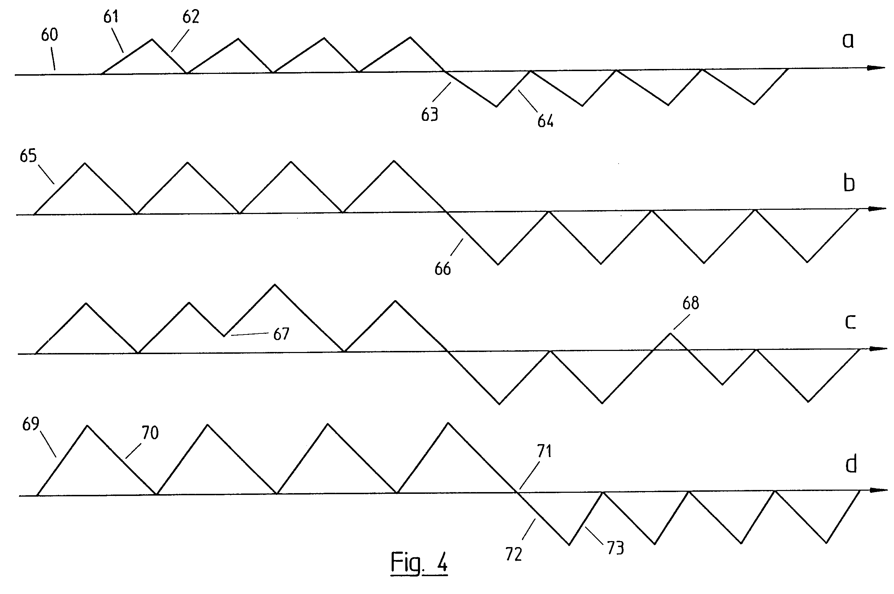

Die Ausgangsspannung des integrierenden Verstärkers 49 ändert sich daher schrittweise linear, wie dies in Figur 4a mit dem Kurventeil 61 gezeigt ist. Die Steigung der Integratorspannung während des Kurventeils 61 ist der zu messenden Kapazität 42 direkt proportional.

Bei dem beschriebenen Ausführungsbeispiel wird das Prinzip des zeitlich mittleren Ladungsgleichgewichts angewendet, um den Einfluß der Betriebsspannung, der Taktfrequenz sowie des Werts des Integrationskondensators 50 zu kompensieren. Die Meßanordnung erzeugt dabei einen Ausgangswert, der das Ergebnis einer Vergleichsmessung der zu messenden Kapazität 42 und des Referenzkondensators 43 darstellt. Es ist allerdings auch möglich, anstelle des Prinzips des zeitlich mittleren Ladungsgleichgewichts die zu messende Kapazität 42 lediglich ein- oder mehrfach zu messen, ohne den Speicherkondensator 43 einzusetzen, wenn die konkreten Schaltungsparameter ausreichend stabil sind.

Ein Zähler 31, der das über den Umschalter 25 abgegriffene Taktsignal über die Leitung 26 an seinem Takteingang empfängt, summiert die Anzahl der Ladungsübertragungsvorgänge und steuert mit seinem Ausgang das Flip-Flop 32. Der Zähler 31 ist auf einen vorbestimmten Zählwert voreingestellt. Nach Zählen einer dem voreingestellten Zählwert entsprechenden Anzahl quantisierter Ladungsübertragungen aus der zu messenden Kapazität 42 gibt der Zähler 31 an das Flip-Flop 32 ein Setzsignal ab, wodurch dieses über seinen Q-Ausgang ein Rücksetzsignal an den Zähler 31 abgibt. Durch die Umschaltung des Flip-Flops 32 wird das Und-Gatter 39 nun gesperrt und statt dessen das Und-Gatter 38 freigegeben. Demzufolge wird der Umschalter 44 nun gesperrt, d. h. dauerhaft in der dargestellten Position gehalten, während der Umschalter 45 entsprechend dem über den Inverter 37 invertierten Taktsignal auf der Leitung 26 umgeschaltet wird. Damit wird nun der Referenzkondensator 43 abwechselnd aufgeladen/entladen, und zwar in derselben Weise, wie dies zuvor anhand der zu messenden Kapazität 42 beschrieben wurde. Aufgrund des Inverters 37 arbeitet das Und-Gatter 38 allerdings im Vergleich zum Und-Gatter 39 mit einer Phasenverschiebung von 180°. Der Ausgangsstrom des als Synchrondemodulator arbeitenden Umschalters 45 besitzt daher eine umgekehrte Polarität, verglichen mit derjenigen des Umschalters 44, so daß der integrierende Verstärker 49 nun aufgrund der polaritätsumgekehrten Ladungsübertragungen zurückintegriert. Hierbei ergibt sich der Kurvenabschnitt 62 gemäß Figur 4a.

Wenn die Ausgangsspannung des integrierenden Verstärkers 49 auf den Wert der durch die Widerstände 51, 52 bestimmten Schaltschwelle des Schwellwertvergleichers 53 absinkt, schaltet dieser um und setzt über das Exklusiv-Oder-Gatter 54 das D-Flip-Flop 55. Dieses setzt über die Leitung 56 das Flip-Flop 32 wieder zurück. Durch dieses Umkippen des Flip-Flops 32 fällt das bislang am Rücksetzeingang des Zählers 31 anliegende Rücksetzsignal wieder auf niedrigen Pegel ab, so daß der Zähler 31 erneut gestartet wird. Zugleich wird das Und-Gatter 39 wieder aktiviert, während das Und-Gatter 38 gesperrt wird. Es beginnt folglich ein neuer Meßzyklus, d. h. ein neuer Sägezahnabschnitt des Signals gemäß Figur 4a, bei dem die zu messende Kapazität 42 erneut geladen/entladen wird und die Aufladung des Integrierkondensators 50 erneut beginnt. Durch mehrfache Wiederholung dieser Umschaltvorgänge ergibt sich die Dreiecksausgangsspannung des integrierenden Verstärkers 49 gemäß Figur 4a. Die Linie 60 dieses Signalzugs entspricht dem Nullpunkt, d. h. der Schaltschwelle des SchwellwertvergleicherS 53.

Das Meßergebnis stellt die Anzahl der Entladezyklen durch den Referenzkondensator 43 dar, die ausgehend von dem bei der festen Anzahl der Ladezyklen durch die zu messende Kapazität 42 erreichten Potentialwert notwendig sind, um auf die Schaltschwelle 60 zurückzuintegrieren. Die Anzahl der benötigten Entladezyklen des Referenzkondensators 43 werden in einem Zähler 28 gezählt, der die vom Und-Gatter 38 abgegebenen Schaltsteuersignale des Umschalters 45 über eine Leitung 29 zählt. Der im Zähler 28 aufsummierte Wert ist direkt proportional zur Größe der zu messenden Kapazität 42.

Der Takteingang des D-Flip-Flops 55 ist mit der Leitung 26 verbunden und wird somit durch diese taktgesteuert. Durch diese Taktsteuerung wird verhindert, daß ein beim Umschalten des Schwellwertvergleichers 53 gerade laufender Ladungstransfer zerstückelt wird. Dieser wird vielmehr vollständig abgeschlossen, bis bei der Umschaltung des Taktsignals dann das D-Flip-Flop 55 über die Leitung 56 das Flip-Flop 32 rücksetzt. Da die jeweils zu viel gemessene Referenzteilladung des Referenzkondensators 43 in den nächsten Meßzyklus übertragen wird, ergibt sich der Vorteil, daß durch mehrfache Wiederholung des Meßzyklus die Auflösung des Meßwerts beliebig gesteigert werden kann, da nun auch Zwischenwerte zwischen ganzen Anzahlen der zur Rückintegration erforderlichen Entladungszyklen des Speicherkondensators 43 erfaßbar sind.

Der Teiler oder Zähler 35 dient zur Umkehrung der Flußrichtung aller Ladungsübertragungsströme in der zweiten Hälfte des Gesamt-Meßzyklus. Der Zähler oder Teiler 35 wird durch das Flip-Flop 32 getaktet und ist auf einen vorbestimmten Zählstand voreingestellt oder auf ein vorbestimmtes Teilungsverhältnis von beispielsweise 4 : 1 (gemäß der Darstellung, das aber in der Praxis 256 : 1 betragen kann) programmiert. Nach Zählung oder Teilung einer entsprechenden Anzahl von Taktungen durch das Flip-Flop 32 wechselt das Ausgangssignal des Zählers oder Teilers 35 von bislang niedrigem auf hohen Pegel und legt diesen an den ihm zugeordneten Eingang des Exklusiv-Oder-Gatters 36 an. Hierdurch invertiert dieses nun das auf der Leitung 26 zugeführte Taktsignal, so daß das Ausgangssignal des Exklusiv-Oder-Gatters 36 um 180° phasenverschoben wird. Hierdurch wird folglich der Signalfluß umgekehrt, so daß auch die Synchrondemodulatoren 44, 45 um 180° phasenverschoben arbeiten. Als Folge hiervon arbeitet der integrierende Verstärker 49 jetzt unterhalb der Schaltschwelle 60 des Schwellwertvergleichers 53, so daß sich die rechte Hälfte des in Figur 4a dargestellten Signalverlaufs ergibt. Der Kurvenabschnitt 63 entspricht hierbei der Aufladung/Entladung der zu messenden Kapazität 42, die dessen Steilheit bestimmt, während der Kurvenabschnitt 64 durch den Referenzkondensator 43 definiert wird. Die Steilheiten der Abschnitte 63, 64 entsprechen, mit Ausnahme des umgekehrten Vorzeichens, denjenigen der Kurvenabschnitte 61, 62.

Wenn der Zähler oder Teiler 35 nach dem Umschalten seines Ausgangspegels erneut eine dem voreingestellten Zählstand oder Teilungsverhältnis entsprechende Anzahl von Eingangsimpulsen vom Flip-Flop 32 erhält, kippt der Zähler oder Teiler 35 wieder in seinen anfänglichen Zustand zurück, so daß sein Ausgangssignal wieder auf niedrigen Pegel wechselt. Mit dem Zurückkippen des Zählers oder Teilers 35 ist ein kompletter Meßzyklenablauf für die Kapazitätsmessung beendet.

Der Zähler 28 zählt die über die Leitung 29 zugeführte Anzahl der notwendigen Entladungen des Referenzkondensators 43 während des gesamten Meßzyklus und enthält damit die Gesamtschrittanzahl aller schrittweise linearen Kurvenabschnitte 62, 64. Über die Leitung 30 erhält der Zähler 28 über einen zweiten Takteingang weiterhin auch das Ausgangssignal des Zählers oder Teilers 35 und erkennt aus dessen erneutem Pegelwechsel die Beendigung des gesamten Meßzyklus. Das dem gesuchten Kapazitätswert der Kapazität 42 entsprechende Ergebnis wird am Ausgang 57 des Zählers 28 in Form eines entsprechenden Zählstands abgegeben. Dieser Zählstand entspricht der Formel

$$y = n_1 \times n_2 \times C_M/C_R,$$

wobei $n_1$ und $n_2$ die Teilerfaktoren der Zähler oder Teiler 31 und 35 bezeichnen.

Durch die vorstehend genannte Umkehrung der Flußrichtung aller Ladungsübertragungsströme für die halbe Anzahl der gesamten Meßzyklensumme lassen sich eine ggf. vorhandene Offsetspannung des integrierenden Verstärkers 49 und auch evtl. Eingangsströme zuverlässig kompensieren.

Bei dieser Invertierung der Flußrichtung der Ladungsströme wird auch dafür Sorge getragen, daß das Durchlaßverhalten des Exklusiv-Oder-Gatters 54 entsprechend invertiert wird, um die Abgabe des Schaltsignals des Schwellwertvergleichers 53 an das Flip-Flop 55 an den jeweiligen Signalpegelverlauf des Ausgangssignals des Schwellwertvergleichers 53 anzupassen. Dies wird erreicht, indem das Exklusiv-Oder-Gatter 54 über die Leitung 30 mit dem Ausgang des Zählers oder Teilers 35 verbunden ist.

Zur Veranschaulichung der erfindungsgemäß erzielbaren vorteilhaften Wirkungen der automatischen Kompensation von Störspannungen/Störströmen sind in den Figuren 4b, 4c und 4d entsprechende Kurvenzüge dargestellt. Figur 4b zeigt den Signalverlauf bei einem größeren Kapazitätswert der zu messenden Kapazität 42. Die durch die Kapazität 42 definierte Steilheit der entsprechenden Abschnitte 65 und 66 (entsprechend den Abschnitten 61 und 63 in Figur 4a) ist daher größer, so daß eine entsprechend größere Anzahl von Ladungstransfers durch den Referenzkondensator 43 erforderlich ist, um wieder auf den Ausgangswert zurückzuintegrieren.

Figur 4c zeigt, daß Schaltpunktinstabilitäten des Schwellwertvergleichers 53, wie sie durch die Punkte 67 und 68 veranschaulicht sind, ohne Auswirkung auf die Messung bleiben. Dies rührt daher, daß der Wert der Schaltschwelle 60 des Schwellwertvergleichers 53 nur als relativer Bezugspunkt dient. Auf diese Weise führen auch dauerhafte Abweichungen des Schaltpunkts zu keinen negativen Auswirkungen auf die Meßgenauigkeit. Daher werden der Wert der Widerstände 51, 52 und deren evtl. Veränderungen sowie die Offsetspannung des Schwellwertvergleichers 53 automatisch kompensiert.

Figur 4d zeigt (stark übertrieben), wie sich die Integratorspannung unter dem Einfluß einer Eingangsoffsetspannung oder von Eingangsströmen des integrierenden Verstärkers 49 ändert. Hierdurch ergibt sich eine Asymmetrie der positiven und negativen Sägezahnabschnitte, so daß die Steilheiten der durch die zu messende Kapazität 42 verursachten positiven und negativen Signalabschnitte 69, 72 unterschiedlich sind. Gleiches gilt für die Steilheiten der durch den Referenzkondensator 43 hervorgerufenen Signalabschnitte 70, 73. In gleicher Weise verschiebt sich der Übergangspunkt 71 zwischen den beiden Abschnitten des Gesamt-Meßzyklus, vergleiche auch die "ungestörten" Verhältnisse gemäß Figur 4b. Dennoch bleibt aufgrund der alternierenden Signalinvertierung das Zahlenverhältnis der Ladungsübertragungen von Meßkapazität 42 und Referenzkondensator 43 konstant, so daß auch der von der Anordnung schließlich erzeugte Meßwert konstant ist, d. h. der beim Kurvenzug gemäß Figur 4d schließlich errechnete Zählwert des Zählers 28 demjenigen entspricht, der im Falle der Kurve Figur 4b erhalten wird. Dies beruht darauf, daß unbeeinflußt durch solche Störungen die Gesamtzahl der Ladungsübertragungen unverändert bleibt.

Der digitale Ausgangswert des Zählers 28 läßt sich bei Bedarf auch in eine proportionale Analogspannung umwandeln, indem beispielsweise das am Ausgang 27 auftretende Signal in ein pulsweitenmoduliertes Rechtecksignal umgewandelt und dieses in eine Analogspannung umgesetzt wird.

Die beschriebene Anordnung eignet sich u. a. auch zur Messung der Temperatur eines Sensors, indem ein temperaturabhängiger Kondensator, z. B. ein Keramikkondensator des Typs N750 (TK-Wert = -750 ppm) eingesetzt wird. Da auch beim Temperaturmeßkondensator die Streukapazitäten neutralisiert werden, kann er an beliebiger Stelle im mechanischen Meßwertaufnehmer angebracht werden, ohne beispielsweise die anderen Meßkapazitäten zu verfälschen.

Weiterhin kann eine Kennlinienkorrektur (Linearität, Temperaturdrift usw.) des gemessenen Sensors auf digitaler Ebene erfolgen, indem anhand von vorab abgespeicherten Stützwerten in Abhängigkeit vom Sensor- bzw. Temperaturmeßwert die Anzahl der Meßladungsübertragungen variiert wird. Dies läßt sich dadurch erreichen, daß die Zähler oder Teiler 31, 35 in ihren Teilerfaktoren gesteuert oder auf bestimmte Korrekturwerte voreingestellt werden.

Aufgrund der phasenselektiven Auswertung der Meßströme werden elektromagnetische Einstreuungen in den Sensoren nicht gemessen.

Weiterhin ist von Vorteil, daß aufgrund der Phasenverschiebung von 90° zwischen den beiden Taktsignalen auf den Leitungen 17, 19 bei gleichstromfreier Auswertung der Sensorkapazität keine Messung parallel liegender Wirkleitwerte stattfindet, die beispielsweise in der Praxis durch Meßzellenfeuchte hervorgerufen werden können. Zur Abkopplung von Gleichstromanteilen kann entweder in Serie zur zu messenden Kapazität 42 ein ausreichend großer Trennkondensator geschaltet oder das Sensor-Massepotential 46 auf den halben Wert der Spannung des Stützkondensators 23, d. h. auf den halben Wert zwischen dem Potential der Leitung 24 und dem Massepotential 22, gelegt werden.

In weiterer Ausgestaltung der Erfindung lassen sich durch einfache Abänderungen der logischen Gatter 36 bis 39 und durch Hinzufügung weiterer Sychrondemodulatoren analog den Umschaltern 44, 45 zusätzliche Kapazitäten auswerten oder auch andere arithmetische Verknüpfungen der Kapazitätsmeßwerte erzeugen, beispielsweise die nachstehenden Verknüpfungen:

$$y \sim C_M/C_R; \quad y \sim C_R/C_M; \quad y \sim (C_M - C_R)/C_R;$$
$$y \sim (C_{M1} - C_{M2})/C_R; \quad y \sim (C_{M1} - C_{M2})/(C_{M1} + C_{M2}).$$

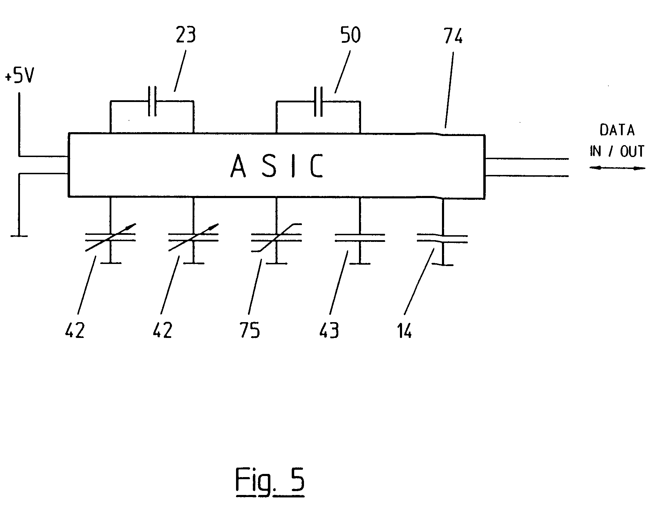

Die beschriebene Meßanordnung eignet sich sehr gut zur monolithischen Integration in CMOS-Technologie in einem ASIC-Baustein. In Figur 5 ist ein Ausführungsbeispiel hierfür gezeigt. Die externe Beschaltung des ASIC-Bausteins 74 kann sich auf die Kondensatoren 14 ($C_{osz}$), 23 ($C_B$) und 50 ($C_i$) beschränken. Der Baustein 74 weist zusätzliche Eingänge für den Anschluß der zu messenden Kapazitäten 42 ($C_{M1}$, $C_{M2}$) und des Referenzkondensators 43 ($C_R$) sowie für einen eventuellen Temperaturmeßkondensator 75 auf. Durch Variation der Werte der Kondensatoren 14 und 50 läßt sich der Kapazitätsmeßbereich der Anordnung an den jeweils auszuwertenden Sensortyp anpassen.

Anstelle des Speicherkondensators 23 kann auch eine anders geartete Hilfsspannungsquelle, beispielsweise in Form einer Batterie, eingesetzt werden.

Bei den vorstehend beschriebenen Ausführungsbeispielen wird der mit dem Umschalter 44 verbundene Anschluß der zu messenden Kapazität in der Ladephase mit dem Sensor-Massepotential 46 und in der Entladephase mit dem invertierenden Eingang des integrierenden Verstärkers 49 gekoppelt. Es ist aber auch die umgekehrte Betriebsweise möglich.

Weiterhin ist es alternativ auch möglich, die - über den Stützkondensator 23 intermittierend aufrechterhaltene - Stromversorgung der Sensor-Auswerteschaltung (d.h. aller Teile unterhalb der Linie 27 in Fig. 3) auf das Potential der Plus-Leitung 10 des Sensors aufzustocken. In diesem Fall wird die Erde 12 (Massepotential des Gesamt-Sensors) nicht an die Leitung 11, sondern an die Leitung 10 angeschlossen.

**Patentansprüche**

1.  Verfahren zur Kapazitätsmessung zumindest einer zu messenden Kapazität, die zunächst in einer Ladephase durch eine vorbestimmte Potentialdifferenz aufgeladen wird und deren dabei gespeicherte Ladung nachfolgend in einer Entladephase mittels eines Integrators (49; 50) ausgewertet wird, wobei die Kapazität (42) mit einem Anschluß mit einem festen Bezugspotential (12) verbunden ist, dadurch gekennzeichnet, daß die Kapazität (42) sowohl in der Ladephase als auch in der Entladephase mit ihrem anderen Anschluß mit Referenzpotential (46), vorzugsweise dem Nullpotential (Massepotential) der Integrator-Versorgungsspannung verbunden wird, und daß das Referenzpotential in der Ladephase auf einen anderen Wert als in der Entladephase gelegt wird.

2.  Verfahren nach Anspruch 1, dadurch gekennzeichnet, daß die Umschaltung der elektronischen Schalter (44, 45) zeitversetzt, vorzugsweise 90° phasenverschoben, zur Umschaltung des Nullpotentials (Schalter (20, 21)) erfolgt.

3.  Verfahren nach Anspruch 1 oder 2, dadurch gekennzeichnet, daß ein Referenzkondensator (43) vorhanden ist und daß die Messung nach dem Prinzip des zeitlich mittleren Ladungsgleichgewichts erfolgt.

4.  Verfahren nach Anspruch 3, dadurch gekennzeichnet, daß die Polarität des in den integrierenden Verstärker (49) fließenden Eingangsstroms nach einer bestimmten Anzahl von Lade-/Entladezyklen umgekehrt wird.

5.  Anordung zur Kapazitätsmessung zumindest einer zu messenden, insbesondere durch einen Sensor gebildeten oder beeinflußten Kapazität (1; 42), die mit einem Anschluß auf festem Bezugspotential, insbesondere Erdpotential (2; 12), liegt und mit ihrem anderen Anschluß in einer Ladephase (oder Entladephase) an ein vorgegebenes Potential gelegt und in einer Entladephase (oder Ladephase) mit einem ersten Eingang eines integrierenden Verstärkers (4; 49) verbunden wird, der die in der Ladephase in der Kapazität (1; 42) gespeicherte Ladung übernimmt, dadurch gekennzeichnet, daß der zweite Eingang des integrierenden Verstärkers (4; 49) dauerhaft mit Sensor-Massepotential (22) oder einem in direkter Beziehung mit diesem stehenden Referenzpotential (46) verbunden ist, und daß der andere Anschluß der zu messenden Kapazität (1; 42) in der Ladephase (oder Entladephase) ebenfalls mit dem an den zweiten Eingang des integrierenden Verstärkers (4; 49) angelegten Potential verbunden ist, das während dieser Ladephase (oder Entladephase) auf einen vom Bezugspotential abweichenden Wert umgeschaltet ist.

6. Anordnung nach Anspruch 5, gekennzeichnet durch eine Hilfsspannungsquelle (7; 23), die wahlweise zwischen das Bezugspotential (12) und das Sensor-Massepotential (22) schaltbar ist.

7. Anordnung nach Anspruch 6, dadurch gekennzeichnet, daß der eine Anschluß der Hilfsspannungsquelle (7; 23) über einen ersten Schalter (20) zwischen Bezugspotential (12) und dem positiven Anschluß (10) der Versorgungsspannung der Gesamtschaltung umschaltbar ist, während der andere Anschluß der Hilfsspannungsquelle (7; 23) über einen zweiten Schalter (21) wahlweise auf das Bezugspotential (12) schaltbar ist.

8. Anordnung nach einem der Ansprüche 5 bis 7, gekennzeichnet durch eine Schaltersteuerschaltung (31 bis 41) zur Steuerung eines ersten Umschalters (44), der mit seinem Mittelkontakt mit der zu messenden Kapazität (42) und mit seinen Schaltkontakten mit dem integrierenden Verstärker (49) und dem Referenzpotential (46), vorzugsweise Massepotential, verbunden ist.

9. Anordnung nach Anspruch 8, gekennzeichnet durch einen Referenzkondensator (43), dessen einer Anschluß mit dem Bezugspotential (12) und dessen anderer Anschluß mit dem Mittelkontakt eines zweiten Umschalters (45) verbunden ist, dessen Schaltkontakte parallel zu denen des ersten Umschalters (44) geschaltet sind.

10. Anordnung nach Anspruch 8 oder 9, dadurch gekennzeichnet, daß die Schaltersteuerschaltung (31 bis 41) den ersten und/oder zweiten Umschalter (44; 45) zeitversetzt gegenüber der Umschaltung des Sensor-Massepotentials (22) steuert.

11. Anordnung nach Anspruch 8, 9 oder 10, dadurch gekennzeichnet, daS die Schaltersteuerschaltung (31 bis 41) einen Taktsignaleingang (26) aufweist, der über einen dritten Umschalter (25) abwechselnd mit dem positiven und dem negativen Anschluß der Hilfsspannungsquelle (23) verbindbar ist.

12. Anordnung nach Anspruch 11 in Verbindung mit Anspruch 7, gekennzeichnet durch einen Taktsignalgenerator (13 bis 16) zur Erzeugung eines Umschaltsignals für die zwischen den Hilfsspannungsquellenanschlüssen und den Versorgungsspannungsanschlüssen liegenden Schalter (20; 21), und durch einen dieses Umschaltsignal empfangenden Phasenschieber (18), dessen Ausgang mit dem Steuereingang des dritten Umschalters (25) verbunden ist.

13. Anordnung nach Anspruch 12, dadurch gekennzeichnet, daß der Taktsignalgenerator (13 bis 16) einen Oszillator (13) mit einem damit verbundenen, das Umschaltsignal erzeugenden Frequenzteiler (15; 16) aufweist, und daß der Phasenschieber (18) als mit dem Frequenzteiler (15; 16) verbundenes taktgesteuertes D-Flip-Flop (18) ausgebildet ist, dessen Takteingang mit dem Oszillator (13) verbunden ist.

14. Anordnung nach einem der Ansprüche 5 bis 13, dadurch gekennzeichnet, daß der integrierende Verstärker (49) zunächst die während jeweils einer Ladephase in der zu messenden Kapazität (42) oder einem Referenzkondensator (43) gespeicherte Ladung für eine vorbestimmte Anzahl von Ladephasen integriert und dann auf einen vorbestimmten wert rückintegriert, wobei die erforderliche Anzahl von Ladephasen des Referenzkondensators (43) oder einer weiteren zu messenden Kapazität durch einen Zähler (28) gezählt wird.

15. Anordnung nach Anspruch 14, dadurch gekennzeichnet, daß der Zyklus der anfänglichen Integration und nachfolgenden Rückintegration mehrfach wiederholt wird.

16. Anordnung nach Anspruch 15, dadurch gekennzeichnet, daß die Schaltersteuerschaltung (31 bis 41) einen Zeitgeber, Zähler oder Teiler (35) aufweist, der nach einer bestimmten Anzahl von Zyklen ein Schaltsignal abgibt, durch das die Polarität des in den integrierenden Verstärker (49) fließenden Eingangsstroms während der nachfolgenden Zyklen umgekehrt wird.

17. Anordnung nach Anspruch 16, gekennzeichnet durch eine durch das Schaltsignal des Zeitgebers, Zählers oder Teilers (35) gesteuerte Torschaltungsanordnung (36), an der das vom dritten Umschalter (25) zugeführte Taktsignal anliegt und die dieses Taktsignal entweder unverändert oder invertiert weiterleitet.

18. Anordnung nach einem der Ansprüche 8 bis 17, dadurch gekennzeichnet, daß mit dem Ausgang des integrierenden Verstärkers (49) ein Schwellwertvergleicher (53) verbunden ist, dessen Ausgangssignal die Schaltersteuerschaltung (31 bis 41) zur Umschaltung des Aufladungs-/Entladungszyklus vom Referenzkondensator (43) auf die zu messende Kapazität (42) bzw. umgekehrt oder zur Beendigung des gesamten Meßvorganges steuert.

19. Anordnung nach Anspruch 18, dadurch gekennzeichnet, daß zwischen den Ausgang des Schwellwertvergleichers (53) und die Schaltersteuerschaltung (31 bis 41) ein Verzögerungsglied (55) geschaltet ist, das das vom Schwellwertvergleicher (53) abgegebene Umschaltsignal bis zur Beendigung des gerade laufenden Entladevorgangs sperrt.

20. Anordnung nach Anspruch 19, dadurch gekennzeichnet, daß das Verzögerungsglied (55) als Flip-Flop ausgebildet ist, das durch das vom dritten Umschalter (25) abgegriffene Taktsignal taktgesteuert wird.

21. Anordnung nach einem der Ansprüche 5 bis 20, dadurch gekennzeichnet, daß das Referenzpotential (46) auf dem halben Wert der Sensor-Versorgungsspannung, vorzugsweise dem halben Wert der Spannung der Hilfsspannungsquelle (7; 23), liegt.

22. Anordnung nach einem der Ansprüche 5 bis 21, dadurch gekennzeichnet, daß ein Speicher zur Vorab-Speicherung von Stützwerten, die das Kennlinienverhalten des gemessenen Sensors in Abhängigkeit von dem jeweiligen Meßparameter repräsentieren, vorhanden ist, und daß eine Steuereinrichtung zur Kennlinienkorrektur des gemessenen Sensors die Anzahl der Meßladungsübertragung in Abhängigkeit vom Sensor-Meßwert variiert.

23. Anordnung nach einem der Ansprüche 5 bis 22, zur Temperaturmessung eines Sensors, dadurch gekennzeichnet, daS die zu messende Kapazität (1; 42) ein temperaturabhängiger Kondensator ist, der mit dem Sensor thermisch gekoppelt ist.

Fig. 1

Fig. 2

Fig. 3

EP 0 600 148 A1

14

Fig. 4

EP 0 600 148 A1

EP 0 600 148 A1

Fig. 5

Europäisches Patentamt

**EUROPÄISCHER RECHERCHENBERICHT**

Nummer der Anmeldung

EP 93 10 9436

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | DE-A-39 42 159 (ENDRESS UND HAUSER) <br> * Zusammenfassung; Ansprüche 1,3-5; Abbildung 3 * <br> * Seite 2, Zeile 33 - Zeile 45 * <br> * Seite 3, Zeile 37 - Zeile 41 * <br> * Seite 3, Zeile 56 - Zeile 57 * <br> * Seite 4, Zeile 1 - Zeile 6 * <br> * Seite 7, Zeile 49 - Zeile 52 * | 6 | G01R27/26 <br> G01D5/24 <br> G01L9/12 |
| X <br> D | & WO-A-91 09278 <br> --- | 1,5 | |
| A | US-A-4 054 833 (D.K.BRIEFER) <br> * Zusammenfassung; Abbildungen 8,9 * <br> * Spalte 6, Zeile 52 - Zeile 66 * <br> * Spalte 8, Zeile 7 - Zeile 22 * <br> --- | 6 | |
| A | GB-A-2 022 271 (GENRAD) <br> * Zusammenfassung; Abbildung 5 * <br> * Seite 3, Zeile 16 - Zeile 18 * <br> --- | 1,5,6 | |
| A | GB-A-2 195 457 (ENDRESS UND HAUSER) <br> * Zusammenfassung; Abbildungen 1,2 * <br> * Seite 6, Zeile 29 - Zeile 43 * <br> --- | 1,5,19 | **RECHERCHIERTE SACHGEBIETE (Int.Cl.5)** |
| A,P | EP-A-0 541 455 (OTIC FISCHER & PORTER) <br> * Zusammenfassung; Abbildungen 1,7 * <br> ----- | 1,5 | G01R <br> G01D <br> G01L <br> G01B |

Der vorliegende Recherchenbericht wurde für alle Patentansprüche erstellt

| Recherchenort | Abschlußdatum der Recherche | Prüfer |
|---|---|---|
| BERLIN | 10. März 1994 | Fritz, S |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.................................................................
& : Mitglied der gleichen Patentfamilie, übereinstimmendes Dokument

EPO FORM 1503 03.82 (P04C03)